# EUROPEAN PATENT APPLICATION

(11) **EP 2 521 170 A2**
(43) Date of publication of application: **07.11.2012**
(21) Application number: 10841260.2
(22) Date of filing: 29.12.2010
(51) Int. Cl.: H01L 23/12, H01L 23/48

(54) **POP PACKAGE AND MANUFACTURING METHOD THEREOF**

(30) Priority: 29.12.2009 KR 20090133352
(71) Applicant: Hana Micron Inc., Chungcheongnam-do 336-864 (KR)
(72) Inventor: LEE, Hyun Woo, Cheonan-si Chungcheongnam-do 330-770 (KR)
(74) Representative: Michalski, Stefan
(86) International application number: PCT/KR2010/009468
(87) International publication number: WO 2011/081428

(57) **Abstract**

The present invention relates to a package on package (POP) package and a manufacturing method thereof, and provides a POP package and a manufacturing method thereof in which the POP package can be implemented by using a transfer mold method without employing a top gate mold method. To this end, the present invention comprises: a lower semiconductor package which includes a first solder ball and a semiconductor chip formed on the upper surface of a substrate, and a mold for molding the semiconductor chip and the solder ball so that a part of the first solder ball may be exposed; and an upper semiconductor package which is stacked so that a connection is made to an exposed part of a second solder ball through the second solder ball formed on the lower surface. Due to said configuration, the present invention prevents chronic defects such as die top delamination caused by the top gate mold method, mold flash, cold solder and the like, and improves the uniformity of processing and the selection of materials.

## Description

### Technical Field

The present invention relates to a POP package and a method of manufacturing the same, and more particularly to a POP package and a method of manufacturing the same which can prevent defects of a package caused by a top gate mold technique by improving a stacked structure of solder balls.

### Background Art

Recent products on which semiconductor packages are mounted are required to be light and compact and to have a number of functions, and thus the trend in the techniques used to manufacture semiconductor package products is to employ a PIP (package in package) process, a POP (package on package) process and the like.

The semiconductor packages are being required to have reduced thickness while having an increasing number of semiconductor chips stacked therein.

To meet these requirements, materials such as EMC (Epoxy molding compound), epoxy and the like, which constitute semiconductor packages, are optimized and used depending on the situation. However, many constraints apply to this.

Meanwhile, a POP package is manufactured in such a way that an upper semiconductor package and a lower semiconductor package, each of which includes a substrate and semiconductor chips mounted on the substrate, are prepared, wherein the upper semiconductor package is molded using a transfer mold process which is dominantly used in the art while the lower semiconductor package is molded using only a top gate mold process, and then the upper semiconductor package is stacked on the lower semiconductor package by means of a solder bump mount (SBM).

However, the conventional POP package inevitably involves the occurrence of chronic defects such as die top delamination caused by the top gate mold process, mold flash, cold solder caused by warpage, and the like.

### Disclosure

### Technical Problem

Accordingly, the present invention has been made keeping in mind the above problems occurring in the prior art, and is intended to provide a POP package and a method of manufacturing the same in which the POP package can be implemented using a transfer mold process without employing a top gate mold process.

### Technical Solution

In order to accomplish the above objects, the present invention provides a POP package comprising: a lower semiconductor package including a substrate, first solder balls and a semiconductor chip formed on an upper surface of the substrate, and a mold which is obtained in a way that molding is conducted on the upper surface of the substrate such that the first solder balls are partially exposed and then the first solder balls are removed at exposed and protruding portions; and an upper semiconductor package including second solder balls formed on a lower surface thereof and at least one semiconductor package, the upper semiconductor being stacked on the lower semiconductor package such that the second solder balls are electrically connected to the exposed portions of the first solder balls.

Preferably, the mold of the lower semiconductor package may be removed from an upper portion thereof by means of grinding or polishing.

Furthermore, the present invention provides a POP package comprising: a lower semiconductor package including a substrate, first solder balls and a semiconductor chip formed on an upper surface of the substrate, and a mold enveloping the first solder balls and the semiconductor chip such that the first solder balls are partially exposed; and an upper semiconductor package including second solder balls formed on a lower surface thereof, the upper semiconductor being stacked on the lower semiconductor package such that the second solder balls are connected to the exposed portions of the first solder balls.

Preferably, at least one of the lower semiconductor package and the upper semiconductor package may be a multi-chip package.

Preferably, the mold may be configured such that the height of a section of the mold positioned at the first solder balls is lower than the height of a section of the mold positioned at the semiconductor chip.

Furthermore, the present invention provides a method of manufacturing a POP package, comprising: preparing an upper semiconductor package and a substrate on which a semiconductor package is mounted; forming solder balls on an upper surface of the substrate; conducting a molding operation on the semiconductor chip and the first solder balls such that the first solder balls are partially exposed; and stacking the upper semiconductor package on the lower semiconductor package such that the second solder balls formed on a lower surface of the upper semiconductor package are electrically connected to the exposed portions of the first solder balls.

Preferably, the molding operation may be conducted such that the height of a section of the mold positioned at the first solder balls is lower than the height of a section of the mold positioned at the semiconductor chip.

Preferably, conducting the molding operation may include removing mold flash formed at the exposed portions of the first solder balls.

Preferably, the molding operation may include removing upper protruding portions of the first solder balls.

### Advantageous Effects

A POP package and a method of manufacturing the same, according to the present invention can prevent chronic defects such as delamination caused by the top gate mold technique, mold flash, cold solder and the like, by implementing a POP package without employing a top gate mold technique, as a result of improving on the stacked structure of solder balls.

### Description of Drawings

FIG. 1 is a cross-sectional view illustrating a POP package according to an embodiment of the present invention;
FIG. 2 is a flowchart illustrating a method of manufacturing a POP package, according to an embodiment of the present invention; and
FIGS. 3a to 3g are cross-sectional views showing the method of manufacturing a POP package, according to an embodiment of the invention.

### <Description of the Reference Numerals in the Drawings>

100: upper semiconductor package
110: first substrate
112: connecting terminal
114: connecting terminal
120: first semiconductor chip
122: chip pad
130: second semiconductor chip
132: chip pad
140: wire
150: mold
160: second solder ball
200: lower semiconductor package
210: second substrate
212: connecting terminal
214: connecting terminal
220: third semiconductor chip
222: chip pad
230: fourth semiconductor chip
232: chip pad
240: wire
250: first solder ball
260: mold
270: solder ball

### Best Mode

Hereinafter, the present invention will be described in detail with reference to a preferred embodiment thereof and the accompanying drawings, so as to allow the present invention to be easily implemented by those having ordinary knowledge in the art. However, the present invention may be modified into a variety of different forms and should not be limited to the embodiment described herein.

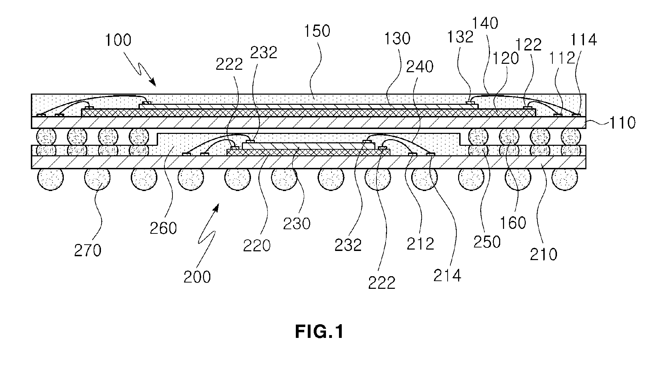

First, a POP package according to an embodiment of the present invention will be described with reference to FIG. 1.

FIG. 1 is a cross-sectional view illustrating the POP package according to the embodiment of the invention.

The POP package comprises an upper semiconductor package 100 which includes a first substrate 110 and first and second semiconductor chips 120 and 130 mounted on the first substrate 110, and a lower semiconductor package 200 which includes a second substrate 210 and third and fourth semiconductor chips 220 and 230 mounted on the second substrate 210.

The upper semiconductor package 100 includes the first substrate 110, the first semiconductor chip 120 mounted on the first substrate 110, the second semiconductor chip 130 attached to the first semiconductor chip 120, wires 140 for wire bonding, a mold 150 which is molded to envelope the upper semiconductor package 100, and solder balls 160 which are provided to be connected to the second substrate 210.

Although the upper semiconductor package 100 is described as being a multi-chip package in this embodiment, it may be composed of a single chip package.

The first substrate 110 is constructed such that the second solder balls 160 are formed on external connecting terminals (not shown) of a lower surface of the first substrate 110, and connecting terminals 112 and 114 are disposed at the opposite sides of the upper surface of the first substrate 110 when making the connection between the first and second semiconductor chips 120 and 130.

The first semiconductor chip 120 is attached to the upper surface of the first substrate 110 by means of adhesive and the like, and opposite sides of the chip 120 are provided with chip pads 122. The chip pads 122 are electrically connected to the connecting terminals 112 of the first substrate 110.

The second semiconductor chip 130 is attached to the upper surface of the first semiconductor chip 120 by means of adhesive and the like, and is provided at the opposite sides thereof with chip pads 132. The chip pads 132 are electrically connected to the connecting terminals 114 of the first substrate 110.

The wires 140 function to connect the chip pads 122 of the first semiconductor chip 120 with the connecting terminals 112 of the first substrate 110 using wire bonding, and the chip pads 132 of the second semiconductor chip 130 are connected to the connecting terminals 114 of the first substrate 110 using wire bonding.

The mold 150 is molded to thoroughly envelope the first semiconductor chip 120 and the second semiconductor chip 130 so as to protect the first semiconductor chip 120 and the second semiconductor chip 130 from external impacts.

The second solder balls 160 function to electrically connect the external connecting terminals (not shown) of the first substrate 110 with the solder balls 250 of the lower semiconductor package 200.

The lower semiconductor package 200 includes the second substrate 210, the third semiconductor chip 220 mounted on the second substrate 210, the fourth semiconductor chip 230 attached to the third semiconductor chip 220, wires 240 for wire bonding, a mold 250 which is molded to envelope the lower semiconductor package 200, the solder balls 250 connected to the second solder balls 160 of the first substrate 110, and solder balls 270 for making the connection to an external device.

Although the lower semiconductor package 200 is described as being a multi-chip package in this embodiment, it may be composed of a single chip package.

The second substrate 210 is constructed such that the second solder balls 270 are formed on external connecting terminals (not shown) of a lower surface of the second substrate 210 and connecting terminals 212 and 214 are disposed at the opposite sides of the upper surface of the second substrate 210 to make a connection to the third and fourth semiconductor chips 220 and 230.

The third semiconductor chip 220 is attached to the upper surface of the second substrate 210 by means of an adhesive and the like, and is provided at the opposite sides thereof with chip pads 222. The chip pads 122 are electrically connected to the connecting terminals 212 of the second substrate 210.

The fourth semiconductor chip 230 is attached to the upper surface of the third semiconductor chip 220 by means of an adhesive and the like, and is provided at the opposite sides thereof with chip pads 232. The chip pads 232 are electrically connected to the connecting terminals 214 of the second substrate 210.

The wires 240 function to connect the chip pads 222 of the third semiconductor chip 220 with the connecting terminals 212 of the second substrate 210 using wire bonding, and the chip pads 232 of the fourth semiconductor chip 230 is connected to the connecting terminals 214 of the second substrate 210 using wire bonding.

The first solder balls 250 are formed on the opposite sides of the second substrate 210 such that the first solder balls 250 are disposed at the locations corresponding to the second solder balls 160.

The mold 260 is molded to thoroughly envelope the third semiconductor chip 220 and the fourth semiconductor chip 230 so as to protect the third semiconductor chip 220 and the fourth semiconductor chip 230 from external impacts. At this point, the mold 260 is configured such that the first solder balls 250 are partially exposed to the outside and the height of the section of the mold 260 positioned at the first solder ball 250 is lower than the height of the section of the mold 260 positioned at the third semiconductor chip 220 and the fourth semiconductor chip 230.

The solder balls 270 function to electrically connect the external connecting terminals (not shown) with an external device (not shown).

With the aid of the above construction, a transfer mold process can be employed even to manufacture the lower semiconductor package although it is usually used in the manufacture of the upper semiconductor package. Hence, defects caused by the top gate mold process can be eliminated.

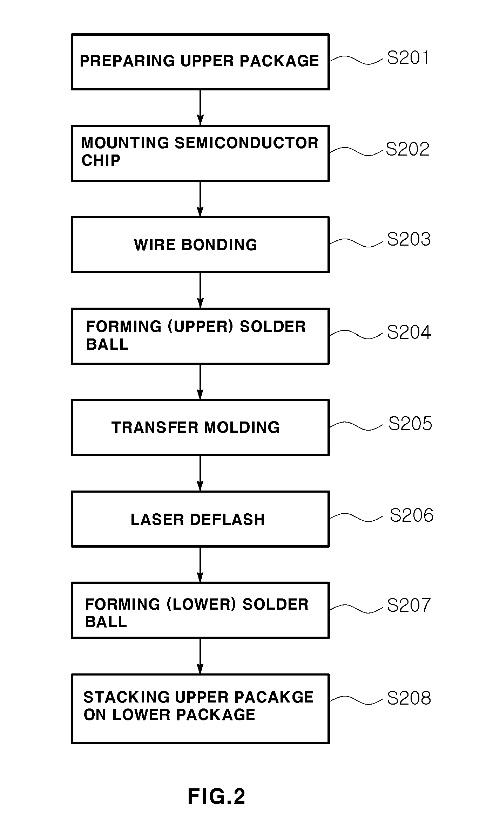

Hereinafter, a method of manufacturing the POP package, according to the present invention will be described with reference to FIGS. 2 to 3f.

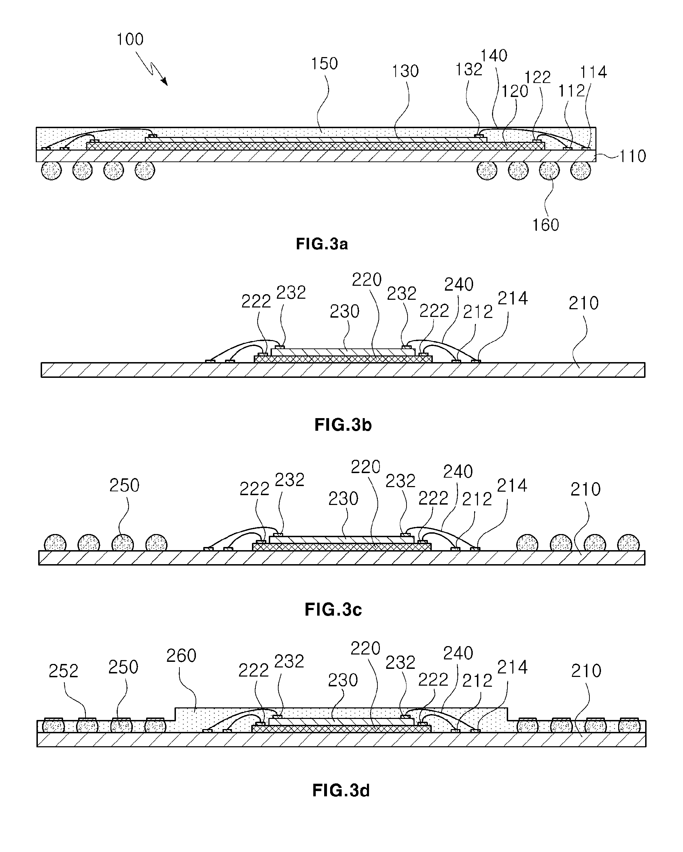

FIG. 2 is a flowchart illustrating the method of manufacturing a POP package, according to an embodiment of the invention, and FIGS. 3a to 3g are cross-sectional views showing the method of manufacturing a POP package, according to an embodiment of the invention.

The method of manufacturing the POP package comprises preparing the upper semiconductor package (S201), constructing the lower semiconductor package 200 (S202 - S207), and stacking the upper semiconductor package 100 on the lower semiconductor package 200.

The construction of the lower semiconductor package 200 comprises mounting the third semiconductor chip 220 and the fourth semiconductor chip 230 (S202), wire-bonding the third semiconductor chip 220 and the fourth semiconductor chip 230 to the second substrate 210 (S203), forming the first solder balls 250 on the upper surface of the second substrate 210 (S204), performing transfer molding onto the lower semiconductor package 200 (S205), removing mold flash formed on the mold 260 (S206), and forming the solder balls 270 on the lower surface of the second substrate 210 (S207).

More specifically, as shown in FIG. 3a, the preparation of the upper semiconductor package 100 (S201) is carried out in the same manner as a conventional process.

In other words, the first semiconductor chip 120 and the second semiconductor chip 130 are mounted on the first substrate 110, and the first semiconductor chip 120 and the second semiconductor chip 130 are wire-bonded to the first substrate 110. Subsequently, transfer molding is conducted on the lower semiconductor package 200. After the mold is cured, the second solder balls 160 are formed on the lower surface of the first substrate 110. In this embodiment, although the upper semiconductor package 100 is illustrated as being a multi-chip package, it may be composed of a single chip package.

As shown in FIG. 3b, in the mounting operation (S202), the third semiconductor chip 220 is adhesively mounted on the upper surface of the second substrate 210, and the fourth semiconductor chip 230 is adhesively mounted on the upper surface of the third semiconductor chip 220 by means of adhesive and the like.

In this regard, the first substrate 110 is constructed in such a way that the connecting terminals 212 and 214 are formed at the opposite sides of the upper surface of the second substrate 210 to make connections to the third semiconductor chip 220 and the fourth semiconductor chip 230, the third semiconductor chip 220 is provided at opposite sides thereof with the chip pads 222, and the fourth semiconductor chip 230 is provided at the opposite sides thereof with the chip pads 232. Although the lower semiconductor package 200 is illustrated as being a multi-chip package, this may be composed of a single chip package.

In the wire-bonding operation (S203), the chip pads 222 of the third semiconductor chip 220 are wire-bonded to the connecting terminals 212 of the second substrate 210 via the wire 240.

As shown in FIG. 3c, in the forming of first solder balls 250 (S204), the first solder balls 250 are formed on the opposite sides of the second substrate 210 such that the first solder balls 250 are disposed at locations corresponding to the second solder balls 160 of the upper semiconductor package 100.

Accordingly, unlike conventional processes, the present invention is capable of minimizing defects such as cold solder caused by warpage by conducting an SBM process prior to the molding process.

In addition, the present invention is capable of employing a transfer mold process which is dominantly used in recent mass production, without employing a top gate mold process. Therefore, defects caused by the top gate mold process can be eliminated by omission of the top gate mold process.

As shown in FIG. 3d, in performing the transfer molding operation (S205), the mold 260 is molded on the third semiconductor chip 220 and the fourth semiconductor chip 230 such that the third semiconductor chip 220 and the fourth semiconductor chip 230 are thoroughly enveloped by the mold 260, thereby protecting the third semiconductor chip 220 and the fourth semiconductor chip 23 from external impacts. At this point, the solder balls 250, which serve as connectors with respect to the upper semiconductor package 100, are partially exposed to the outside rather than being thoroughly enveloped by the mold. In other words, the molding is conducted such that a height of the section of the mold positioned at the first solder balls 250 is lower than a height of the section of the mold positioned at the third semiconductor chip 220 and the fourth semiconductor chip 230.

As mentioned above, the molding process may be a transfer mold process which is being dominantly used these days. After the molding operation, a series of curing processes are conducted.

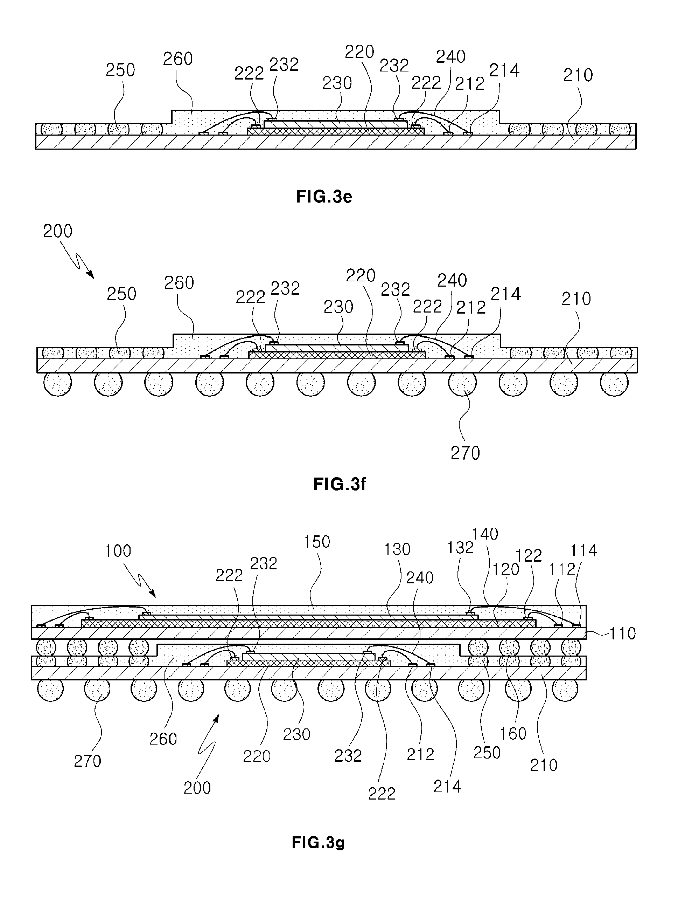

As shown in FIG. 3e, in removing the mold flash (S206), the mold flash 252 which is formed on exposed areas of the first solder balls 250 in the molding operation is removed. In other words, after the SBM process, a laser deflash process is conducted concurrently with a marking process which is conducted on the surface of the mold 260, in order to remove the mold flash 252 which may be formed on the first solder balls 250 during the molding process.

As shown in FIG. 3f, in forming the solder balls 270 (S207), the solder balls 270 are formed on the second substrate 210 so as to electrically connect the external connecting terminals (not shown) with an external device (not shown).

As shown in FIG. 3g, in a stacking operation (S208), the upper semiconductor package 100 is stacked on the lower semiconductor package 200; however, between the upper semiconductor package 100 and the lower semiconductor package 200, there are second solder balls 160 which are formed on the lower surface of the upper semiconductor package 100. At this point, the second solder balls 160 are positioned such that the second solder balls 160 are connected to the exposed areas of the first solder balls 250, and then the stacking is conducted, thus providing a finished POP package.

According to the above method, the present invention allows free selection of applicable one among many materials such as EMC, epoxy and the like and improved process stabilization. Furthermore, the present invention enables POP packages to be manufactured by a transfer mold process which is dominantly used in the art, without employing a top gate mold process.

While the preferred embodiment of the present invention has been disclosed, the present invention is not limited to the embodiment and may have various modifications without departing from the scope and spirit of the invention, and thus the modifications should be construed as falling within the scope of the present invention which is defined by the accompanying claims.

## Claims

1. A POP package comprising:
a lower semiconductor package including a substrate, first solder balls and a semiconductor chip formed on an upper surface of the substrate, and a mold which is obtained in a way that molding is conducted on the upper surface of the substrate such that the first solder balls are partially exposed and then the first solder balls are removed at exposed and protruding portions; and
an upper semiconductor package including second solder balls formed on a lower surface thereof and at least one semiconductor package, the upper semiconductor being stacked on the lower semiconductor package such that the second solder balls are electrically connected to the exposed portions of the first solder balls.

2. The POP package according to claim 1, wherein the mold of the lower semiconductor package is removed from an upper portion thereof by means of grinding or polishing.

3. A POP package comprising:
a lower semiconductor package including a substrate, first solder balls and a semiconductor chip formed on an upper surface of the substrate, and a mold enveloping the first solder balls and the semiconductor chip such that the first solder balls are partially exposed; and
an upper semiconductor package including second solder balls formed on a lower surface thereof, the upper semiconductor being stacked on the lower semiconductor package such that the second solder balls are connected to the exposed portions of the first solder balls.

4. The POP package according to claim 3, wherein at least one of the lower semiconductor package and the upper semiconductor package is a multi-chip package.

5. The POP package according to claim 3, wherein the mold is configured such that a height of a section of the mold positioned at the first solder balls is lower than a height of a section of the mold positioned at the semiconductor chip.

6. A method of manufacturing a POP package, comprising:
preparing an upper semiconductor package and a substrate on which a semiconductor package is mounted;
forming solder balls on an upper surface of the substrate;
conducting a molding operation on the semiconductor chip and the first solder balls such that the first solder balls are partially exposed; and
stacking the upper semiconductor package on the lower semiconductor package such that the second solder balls formed on a lower surface of the upper semiconductor package are electrically connected to the exposed portions of the first solder balls.

7. The method according to claim 6, wherein the molding operation is conducted such that a height of a section of the mold positioned at the first solder balls is lower than a height of a section of the mold positioned at the semiconductor chip.

8. The method according to claim 6, wherein the molding operation comprises removing mold flash formed at the exposed portions of the first solder balls.

9. The method according to claim 6, wherein conducting the molding operation comprises removing upper protruding portions of the first solder balls.
